# EUROPEAN PATENT SPECIFICATION

(11) **EP 0 414 257 B1**
(45) Date of publication and mention of the grant of the patent: **15.10.2003**
(21) Application number: 90116251.1
(22) Date of filing: 24.08.1990
(51) Int. Cl.: H01L 23/495, H01L 23/31, H01L 23/16, H01L 23/488

(54) **Resin sealing type semiconductor device in which a very small semiconductor chip is sealed in package with resin**
Halbleiteranordnung des Harzverkapselungstyps, in dem ein sehr kleiner Halbleiterchip mit Harz versiegelt ist
Dispositif semi-conducteur du type à encapsulation par résine dans lequel un très petit chip semi-conducteur est scellé dans une résine

(30) Priority: 25.08.1989 JP 21940489; 29.06.1990 JP 17306590
(43) Date of publication of application: 27.02.1991
(73) Proprietor: KABUSHIKI KAISHA TOSHIBA, Kawasaki-shi, Kanagawa-ken 210-8572 (JP)
(72) Inventor: Sawaya, Hiromichi, c/o Intellectual Property Div., Minato-ku, Tokyo 105 (JP)
(74) Representative: Lehn, Werner, Dipl.-Ing.

(56) References cited:
- EP-A- 0 247 644
- EP-A- 0 247 775
- EP-A- 0 350 833
- WO-A-88/05962
- PATENT ABSTRACTS OF JAPAN vol. 10, no. 158 (E-409)(2214) 06 June 1986, & JP-A-61 014731 (KANSAI NIPPON DENKI K.K.) 22 January 1986,
- PATENT ABSTRACTS OF JAPAN vol. 7, no. 214 (E-199)(1359) 21 September 1983, & JP-A-58 107659 (SEIKOO KEIYOU KOGYO K.K.) 27 June 1983,

## Description

The present invention relates to a moulded material type semiconductor device for sealing a very small semiconductor chip in a package.

Semiconductor chips have been reduced in size in accordance with miniaturization of elements. Generally, as the size of a semiconductor chip decreases, the mechanical stress thereof lowers and thus the semiconductor chip is more difficult to be broken. The small semiconductor chip is more reliable about a variation in temperature than a large one and it can be manufactured at low cost. Using small semiconductor chips, a semiconductor device whose operating speed is high, power consumption is low, and electrical characteristic are good, can be achieved.

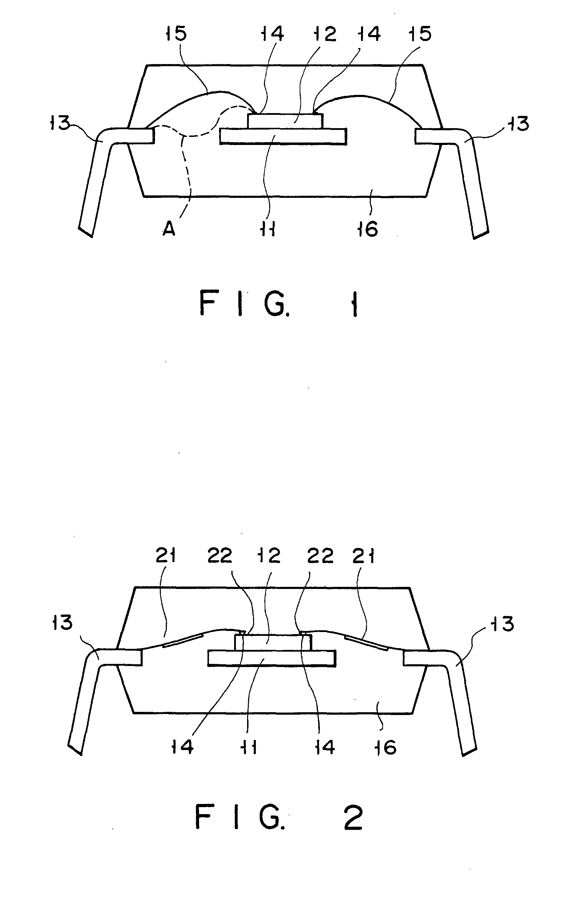

Fig. 1 is a cross sectional view showing a semiconductor device in which a very small semiconductor chip having the above-described features is sealed with resin. Semiconductor chip 12 is die-bonded onto bed 11 of a lead frame, lead 13 of the lead frame is connected to electrode pad 14 on chip 12 by bonding wire 15 and they are sealed in with mold resin 16. Since the lead frame to be processed is limited in size, lead 13 cannot be arranged sufficiently close to semiconductor chip 12 and inevitably bonding wire 15 is lengthened.

Although bonding wire 15 is in a correct position before the semiconductor chip is sealed in with resin, it is deformed by the pressure exerted during the resin sealing as indicated by broken line A in Fig. 1 and is brought into contact with another bonding wire. There is a strong possibility that bonding wire 15 becomes defective.

As one of methods for solving the above problem, it is known to connect chip 12 and lead 13 by TAB (Tape Automated Bonding) tape 21 using a TAB technique, as shown in Fig. 2. The TAB technique is as follows. TAB tape 21 is formed by sticking electrode pad 14 and a thin-film wire made of Cu or the like corresponding to lead 13 on a resin film, and the TAB tape allows electrode pad 14 and lead 13 to be bonded at once.

TAB tape 21 is resistible to the pressure exerted when the chip is sealed in with resin and thus not deformed. Since electrode pad 14 and lead 13 can be bonded at once, the productivity of semiconductor devices is high. According to the TAB technique, however, a bump (projected electrode) 22 needs to be formed on electrode pad 14 so that the electrode pad does not contact the edge of the chip or the chip is not damaged by the bonding operation, and a special device for forming the bump is required. For this reason, an equipment investment in manufacturing process increases the manufacturing cost and it is economically difficult to apply the TAB technique to the semiconductor device of the present invention whose price is low.

It is accordingly a first object of the present invention to provide a resin sealing type semiconductor device which prevents defects from being caused by deformation of a wire when a semiconductor chip is sealed in with resin and which can thus be manufactured at relatively low cost. It is a second object of the present invention to provide a resin sealing type semiconductor device which suppresses an increase in cost of equipment investment in manufacturing process and whose manufacturing cost is relatively low, reliability is high and productivity is high.

Various IC packages are known comprising an assembly that is encapsulated to form an IC package.

WO 88/05962 discloses a semiconductor device comprising a chip secured by means of a die attach pad to an element. Band wires connect the chip electrodes to an arrangement of inner lead fingers on the element to which the chip is secured.

In EP-A-0 247 644, the electrodes of a chip on a mounting surface are connected to the conductors of a surrounding lead frame via conductive pathways on an insulating bridging member inserted in the gap between the periphery of the chip and the inside edges of the lead frame, inner and outer band wires interconnect the chip electrodes and the inner ends of the conductive pathways, and the outer ends of the conductive pathways and the conductors of the lead frame, respectively.

According to EP-A-0 350 833, the electrodes of chips secured on a base member, as well as external leads, are connected respectively to bonding pads on the base member.

With reference to Patent Abstracts of Japan 10(158), (E-409) [2214] and JP-A-61 014 731, there is disclosed an assembly comprising a circuit board having circuit element patterns and various circuit devices thereon, which are interconnected between a semiconductor pellet on the board and conductive leads of a surrounding lead frame also mounted on the board. Conductive interconnections between the pellet and the leads is via electrical connecting wires.

Lastly, EP-A-0 247 775 discloses a lead frame comprising a central paddle having a semiconductor chip thereon and a surrounding arrangement of outer conductive fingers. An insulating tape bearing inner conductive fingers is applied to the top surface of the paddle around the outer marginal edge and may overlap the same. Each inner conductive finger on the tape is bonded to a respective outer conductive finger and also connected by a bonding wire a respective pad on the periphery of the chip.

The present invention is defined in claims 1 and 4, respectively.

With the structure of the semiconductor device, an interval between the bed and each of the leads can be supplemented with the printed circuit board which is fixed so as to overhang from the bed and on which the wiring pattern is formed. The distance between the electrode pads and the printed circuit board is thus shortened. Since the semiconductor chip and the leads are connected via the substrate, the reliability of the semiconductor device becomes high without adopting the TAB technique wherein bumps need to be formed on the chip when the chip and leads are directly connected to each other.

This invention can be more fully understood from the following detailed description given by way of example and when taken in conjunction with the accompanying drawings, in which:
Fig. 1 is a cross sectional view of a conventional resin sealing type semiconductor device in which a very small semiconductor chip is sealed with resin;
Fig. 2 is a cross sectional view of the conventional semiconductor device shown in Fig. 1 in which the semiconductor chip is connected to leads of lead frames using the TAB technique;
Fig. 3 is a cross sectional view of a resin sealing type semiconductor device according to an embodiment of the present invention in which a very small semiconductor chip is sealed with resin;
Figs. 4-6 are cross sectional views of modified resin sealing type semiconductor device which are not embodiments of the present invention but are included as comparative examples.
Fig. 7 is a perspective view of an MCP (multi chip package) to which the structure of the semiconductor chip shown in Fig. 3 is applied, according to a second embodiment of the present invention; and
Fig. 8 is a cross sectional view of the MCP shown in Fig. 7 which is sealed with resin.

The embodiments of the present invention and the comparative examples will now be described with reference to accompanying drawings.

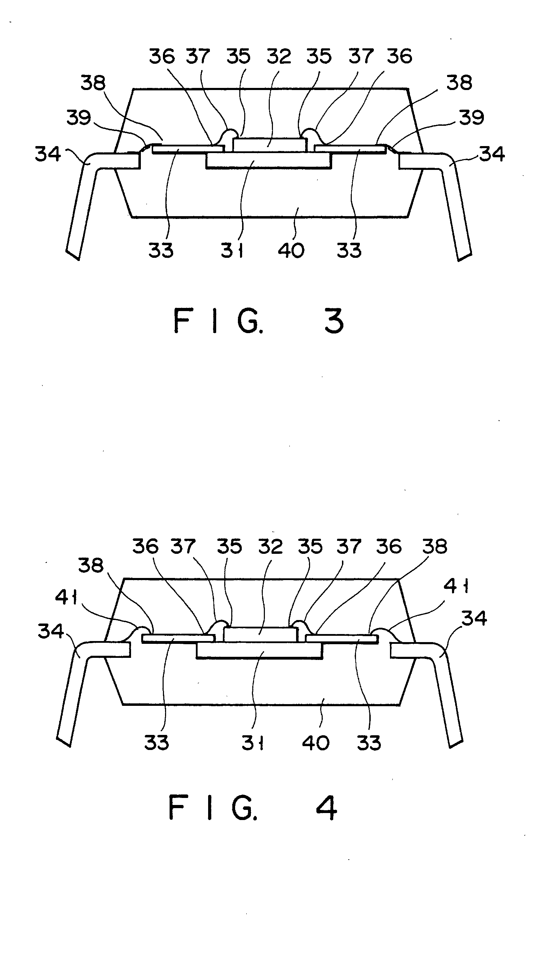

Fig. 3 is a cross-sectional view of the configuration of a resin sealing type semiconductor device according to a preferred embodiment of the present invention. Semiconductor chip 32 is die-bonded onto bed 31 of a lead frame by solder or conductive epoxy resin. Insulation wiring substrate 33 is fixed to an end portion on the surface of bed 31 so as to overhang from bed 31. A plurality of desired wiring patterns, not shown, is formed on printed circuit board 33, and printed circuit board 33 is used to connect lead 34 of the lead frame and semiconductor chip 32 which cannot be made close to each other any more in view of processing dimensions. Each of a plurality of I/O electrode pads 35 formed on chip 32 is connected to one 36 of connecting terminals of substrate 33 by means of bonding wire 37, and lead 34 is connected to the other connecting terminal 38 of substrate by means of TAB tape 39. Semiconductor chip 32 including printed circuit board 33 is then covered with mold resin 40, and part of lead 34 is exposed outside as an outer lead.

According to this embodiment, in a semiconductor device produced by sealing very small semiconductor chip 32 in a package with resin, the deformation of bonding wire 37 due to pressure applied when the sealing operation is performed, neither causes any short circuit nor affects the reliability of the semiconductor device since the bonding wire is short. Even if such a bonding wire is used, the yield can be improved. Since semiconductor chip 32 and printed circuit board 33 are connected by bonding wire 37, no special device need to be used for forming bumps (projected electrodes) on I/O electrode pad 35 of chip 32. It is thus only an OLB (outer lead bonding) apparatus for connecting printed circuit board 33 and lead 34 by TAB tape 39 that is required as a new equipment. The investment in equipment in the manufacturing process can thus be reduced.

In the semiconductor device whose price is low and in which bumps are formed on electrode pad 35 and it is economically difficult to connect electrode 35 and lead 34 and by the TAB tape, if printed circuit board 33 is formed, the semiconductor device can be manufactured with high reliability and at low cost.

Furthermore, since the TAB technique is used to connect printed circuit board 33 and lead 34, the productivity of semiconductor devices can be enhanced. No bumps need to be formed and thus the manufacturing cost of the semiconductor devices is not increased.

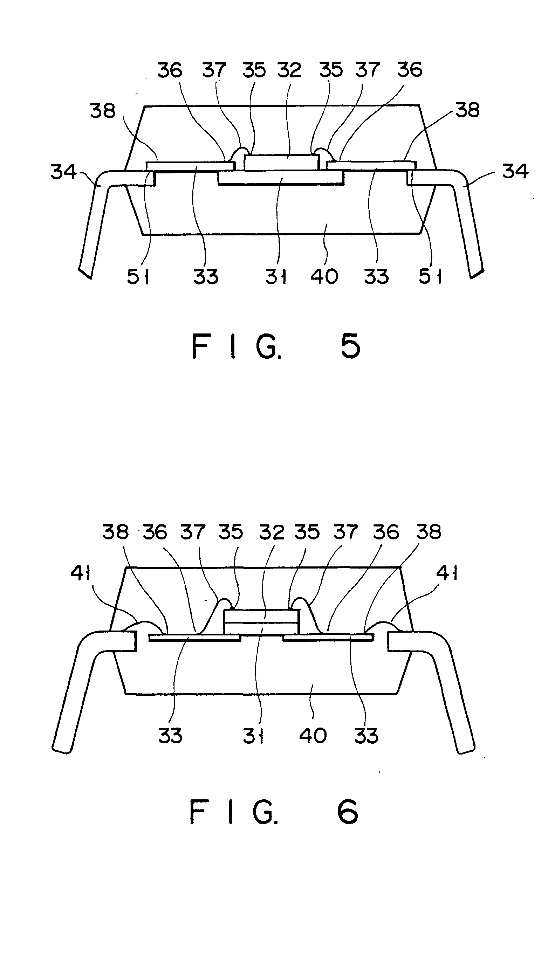

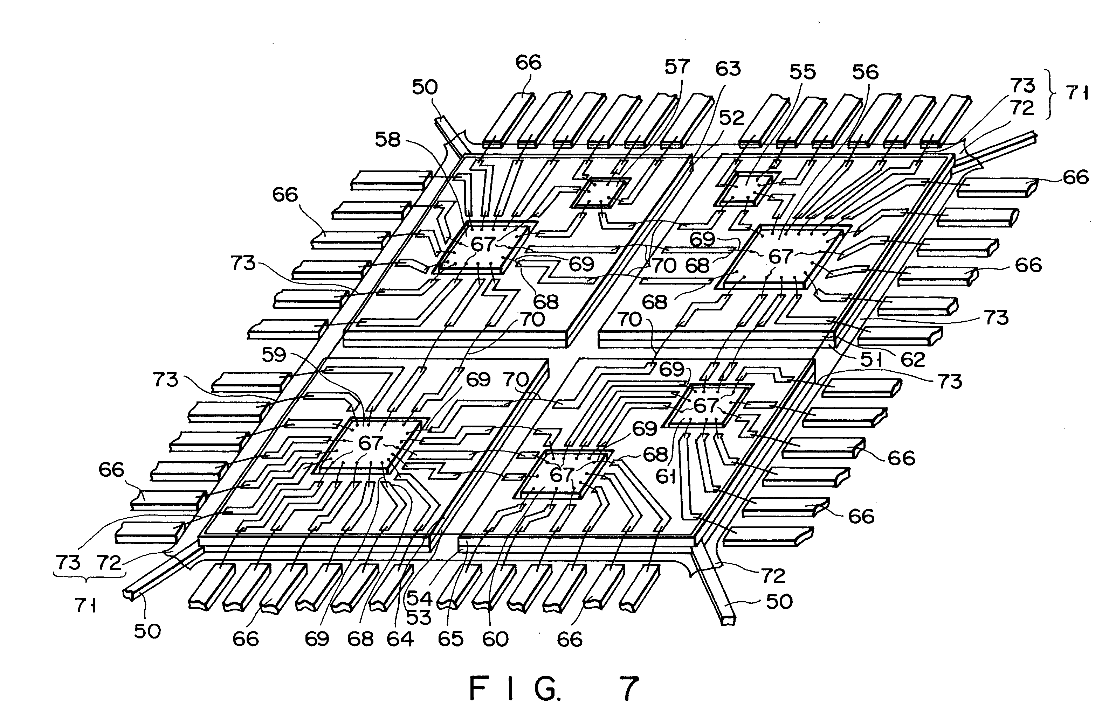

The methods of electrically connecting chip 32 and printed circuit board 33 and electrically connecting printed circuit board 33 and lead 34 are not limited to the Figure 3 embodiment. For example, with reference to the illustrated comparative examples, as shown in Fig. 4, printed circuit board 33 and lead 34 can be connected to each other by bonding wire 41. As illustrated in Fig. 5, the electrical connection of printed circuit board 33 and lead 34 can be performed by forming contact portion 51 on the undersurface of printed circuit board 33 using a wireless bonding technique. It is therefore necessary only to perform a bonding operation which is the most suitable for a semiconductor chip. If bed 31 is small and has no space for fixing printed circuit board 33, board 33 can be fixed not onto the surface but onto the undersurface of bed 31, as shown in Fig. 6. Fig. 7 illustrates an MCP (multi chip package) to which the semiconductor chip shown in Fig. 3 is applied.

As illustrated in Fig. 7, semiconductor chips 55-61 are properly arranged and die-bonded onto beds 51-54 of lead frames fixed by hanging pins 50. Printed circuit boards 62-65 are formed on beds 51-54 so as to surround the semiconductor chips. A desired wiring pattern is formed on each of printed circuit boards 62-65 and used to electrically connect lead 66 and each of chips 55-61, which cannot be made close to each other any more in view of processing dimensions, and to connect chips 55-61 to one another. A plurality of I/O electrode pads 67 formed on the surface of each of chips 55-61 is connected by bonding wires 69 to connecting terminals 68 of the wiring patterns, which are near the semiconductor chips. The connecting terminals of the wiring patterns, which are near the periphery of one of printed circuit boards 62-65, are connected to the wiring patterns of other printed circuit boards and electrically connected to leads 66. The former connection is performed by bonding wires 70, and the latter connection is performed by TAB tapes 71 using the TAB technique. TAB tape 71 is obtained by forming lead line 73 plated with copper on polyamide film 72 so as to correspond to lead 66. The connecting terminals of each of printed circuit boards 62-65 are connected to their corresponding leads 66 at once.

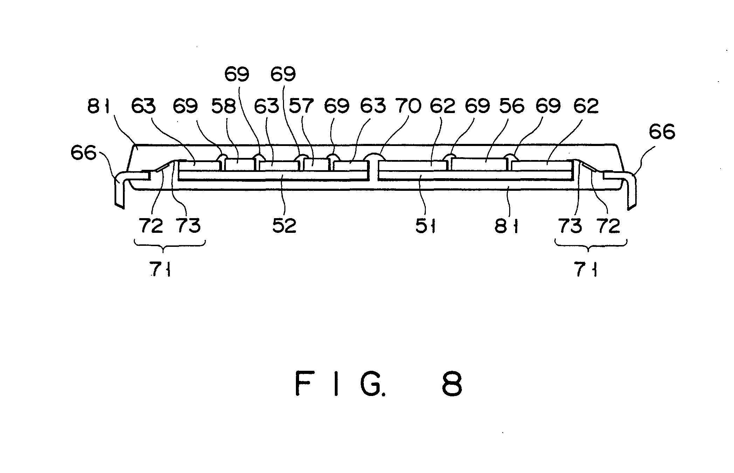

Fig. 8 is a cross sectional view of the MCP shown in Fig. 7 which is sealed with resin. In Fig. 8, the same elements as those in Fig. 7 are denoted by the same reference numerals. The printed circuit boards are connected to each other by bonding wires, and the semiconductor chips are connected to printed circuit boards by bonding wires. The printed circuit boards are connected to their corresponding leads 66 by TAB tapes 71. The MCP is thus sealed with mold resin 81. Like the structure shown in Fig. 3, no bumps need to be formed, so that the manufacturing cost is not so increased, and an MCP of a multi-pin structure having a great large number of leads 66 is improved in reliability and productivity.

As described above, according to the disclosed embodiments of the present invention, a resin sealing type semiconductor device whose price is low and reliability is high can be provided, and an MCP can be improved in reliability and productivity.

Reference signs in the claims are intended for better understanding and shall not limit the scope.

## Claims

1. A moulded material type semiconductor device for sealing a very small semiconductor chip (32) in a package, having a plurality of electrodes (35) arranged on a surface of the semiconductor chip (32), comprising:
a bed (31) having a surface on which said semiconductor chip (32) is mounted, said surface having a peripheral surface portion extending beyond the periphery of said semiconductor chip (32) ;
a plurality of leads (34) surrounding said bed (31);
a printed circuit board (33) having a wiring pattern theron having first and second ends (36, 38), provided between said semiconductor chip (32) and said leads (34);
first connecting means (37) connecting the electrodes (35) on said semiconductor chip (32) to the first end (36) of the wiring pattern on the surface of said printed circuit board (33);
second connecting means (39) connecting said leads (34) to the second end (38) of the wiring pattern on the surface of said printed circuit board (33); and
moulded material (40) covering said semiconductor device with parts of said leads (34) left uncovered;
said moulded material (40) being moulded resin;
said printed circuit board (33) having an underside surface portion at an inner side of the printed circuit board (33), said underside surface portion being part of the opposite surface of said printed circuit board (33) to that having said wiring pattern arranged theron, and overlapping and being fixed to said peripheral surface portion of the bed (31) surrounding said semiconductor chip (32) without contact between said printed circuit board (33) and said chip (32); and
said first connecting means being bonding wires (37) and said second connecting means being TAB tape (39).

2. A moulded material sealing type semiconductor device according to claim 1, wherein:
a bump is provided on the second end (38) of the wiring pattern; and said TAB tape (39)
uses said bump provided on said wiring pattern for the connections between said second end of the wiring pattern of the printed circuit board (33) and said leads (34).

3. A moulded material sealing type semiconductor device according to claim 1, wherein said TAB tape (39) uses no bumps provided on said printed circuit board (33) and said leads (34) for the connections between the second end of the wiring pattern of the printed circuit board (33) and said leads (34) .

4. A moulded material type semiconductor device for sealing a plurality of very small semiconductor chips (55-61) in a package, having a plurality of electrodes (67) arranged on a surface of the semiconductor chip (55-61), comprising:
a plurality of beds (51-54) each having a surface on which at least one of said semiconductor chips (55-61) is mounted, said surface having a peripheral surface portion extending beyond the periphery of said semiconductor chip (55-61);
a plurality of leads (66) surrounding said plurality of beds (51-54);
a plurality of printed circuit boards (62-65) each having a wiring pattern thereon having first and second ends, provided between said semiconductor chip (55-61) and said leads (66);
bonding wires (69) connecting the electrodes (67) on each of said semiconductor chips (55-61) to the first end (68) of the wiring pattern on the surface of the corresponding printed circuit board (62-65);
TAB tape (71) connecting said leads (66) to second ends of the wiring pattern on the surface of said printed circuit boards (62-65); and
moulded material (81) covering said semiconductor device with parts of said leads (66) left uncovered;
said moulded material (81) being moulded resin;
each of said printed circuit boards (62-65) having an underside surface portion being fixed to said peripheral surface portion of the bed (51-54) surrounding said semiconductor chip (55-61) without contact between said printed circuit board (62-65) and said chip (55-61);
at least one opening being formed in each of the printed circuit boards (62-65) for enclosing therein a respective semiconductor chip (55-61) in the or each opening;
connecting terminals of neighbouring printed circuit boards being connected by bonding wires (70); and
connecting terminals facing the leads (66) and the leads being connected via said TAB tapes (71).

## Patentansprüche

1. Eine Halbleitervorrichtung vom Typ mit Formmaterial, zum Abdichten eines sehr kleinen Halbleiterchips (32) in einer Packung, mit einer Vielzahl von Elektroden (35), die auf einer Oberfläche des Halbleiterchips (32) angeordnet sind, umfassend:
ein Bett (31) mit einer Oberfläche, auf der der Halbleiterchip (32) befestigt ist, wobei die Oberfläche einen peripheren Oberflächenabschnitt aufweist, der sich über die Peripherie des Halbleiterchips (32) hinaus erstreckt;
eine Vielzahl von Leitern (34), die das Bett (31) umgeben;
eine gedruckte Schaltplatte (33) mit einem Verdrahtungsmuster darauf mit ersten und zweiten Enden (36, 38), die zwischen dem Halbleiterchip (32) und den Leitern (34) bereitgestellt sind;
eine erste Verbindungseinrichtung (37), zum Verbinden der Elektroden (35) auf dem Halbleiterchip (32) mit dem ersten Ende (36) des Verdrahtungsmusters auf der Oberfläche der gedruckten Schaltplatte (33) verbindet;
eine zweite Verbindungseinrichtung (39) zum Verbinden der Leiter (34) mit dem zweiten Ende (38) des Verdrahtungsmusters auf der Oberfläche der gedruckten Schaltplatte (33); und
Formmaterial (40), das die Halbleitervorrichtung bedeckt, wobei Teile der Leitungen (34) unbedeckt bleiben;
wobei das Formmaterial (40) Formharz ist;
die gedruckte Schaltplatte (33) einen Unterseitenoberflächenabschnitt an einer inneren Seite der gedruckten Schaltplatte (33) aufweist, wobei der Unterseitenoberflächenabschnitt Teil der Oberfläche der gedruckten Schaltplatte (33) ist, die gegenüberliegend der liegt, auf der das Verdrahtungsmuster angeordnet ist, und mit dem peripheren Oberflächenabschnitt des Bettes (31), das den Halbleiterchip (32) umgibt, überlappt und daran befestigt ist, ohne Kontakt zwischen der gedruckten Schaltplatte(33) und dem Chip (32); und
wobei die erste Verbindungseinrichtung Bondingdrähte (37) und die zweite Verbindungseinrichtung TAB-Band (3) ist.

2. Eine Halbleitervorrichtung vom Typ mit Formmaterialabdichtung nach Anspruch 1, wobei:
eine Erhebung auf dem zweiten Ende (38) des Verdrahtungsmusters bereitgestellt ist;
und wobei das TAB-Band (39) die auf dem Verdrahtungsmuster bereitgestellte Erhebung für die Verbindungen zwischen dem zweiten Ende des Verdrahtungsmusters der gedruckten Schaltplatte (33) und den Leiter (34) verwendet.

3. Eine Halbleitervorrichtung vom Typ mit Formmaterialabdichtung nach Anspruch 1, wobei das TAB-Band (39) keine auf der gedruckten Schaltplatte (33) und den Leitern (34) bereitgestellten Erhebungen für die Verbindungen zwischen dem zweiten Ende des Verdrahtungsmusters der gedruckten Schaltplatte (33) und den Leitern (34) verwendet.

4. Eine Halbleitervorrichtung vom Formmaterialtyp zum Abdichten einer Vielzahl von sehr kleinen Halbleiterchips (55-61) in einer Packung, mit einer Vielzahl von Elektroden (67), die auf einer Oberfläche des Halbleiterchips (55-61) angeordnet sind, umfassend:
eine Vielzahl von Betten (51-54), jedes mit einer Oberfläche, auf der mindestens einer der Halbleiterchips (55-61) befestigt ist, wobei die Oberfläche einen peripheren Oberflächenabschnitt aufweist, der sich über die Peripherie des Halbleiterchips (55-61) hinaus erstreckt;
eine Vielzahl von Leitern (66), die die Vielzahl von Betten (51-54) umgeben;
eine Vielzahl von gedruckten Schaltungsplatten (62-65), die jede ein Verdrahtungsmuster darauf aufweisen, mit ersten und zweiten Enden, bereitgestellt zwischen dem Halbleiterchip (55-61) und den Leitungen (66);
Bondingdrähte (69), die die Elektroden (67) auf jedem der Halbleiterchips (55-61) mit dem ersten Ende (68) des Verdrahtungsmusters der Oberfläche der entsprechenden gedruckten Schaltplatten (62-65) verbinden;
TAB-Band (71), das die Leitungen (66) mit zweiten Enden des Verdrahtungsmusters auf der Oberfläche der gedruckten Schaltplatten (62-65) verbindet; und
Formmaterial (81), das die Halbleitervorrichtung bedeckt, wobei Teile der Leitungen (66) unbedeckt verbleiben;
wobei das Formmaterial (81) Formharz ist;
jede der gedruckten Schaltplatten (62-65) einen Unterseitenoberflächenabschnitt aufweist, der an dem peripheren Oberflächenabschnitt des Bettes (51-54), das den Halbleiterchip (55-61) umgibt, befestigt ist, ohne Kontakt zwischen der gedruckten Schaltplatte (62-65) und dem Chip (55-61);
mindestens eine Öffnung in jeder der gedruckten Schaltplatten (62-65) ausgebildet ist, zum darin Einschließen eines jeweiligen Halbleiterchips (55-61) in der oder jeder Öffnung;
Verbindungsanschlüsse von benachbarten gedruckten Schaltplatten, die durch Bondingdrähte (70) verbunden sind; und
Verbindungsanschlüsse, die den Leitungen (66) gegenüber liegen, und wobei die Leitungen über die TAB-Bänder (71) verbunden sind.

## Revendications

1. Dispositif à semiconducteur du type à matériau moulé, permettant l'encapsulation d'une très petite puce semiconductrice (32) dans un boîtier, possédant plusieurs électrodes (35) disposées sur une surface de la puce semiconductrice (32), comprenant :
une base (31) qui possède une surface sur laquelle ladite puce semiconductrice (32) est montée, ladite surface ayant une partie de surface périphérique qui s'étend au-delà de la périphérie de ladite puce semiconductrice (32) ;
une pluralité de fils de sortie (34) entourant ladite base (31) ;
une carte de circuit imprimé (33) portant un motif de câblage ayant des première et deuxième extrémités (36, 38), se trouvant entre ladite puce semiconductrice (32) et lesdits fils de sortie (34) ;
un premier moyen de connexion (37) connectant les électrodes (35) présentes sur ladite puce semiconductrice (32) à la première extrémité (36) du motif de câblage présent à la surface de ladite carte de circuit imprimé (33) ;
un deuxième moyen de connexion (39) connectant lesdits fils de sortie (34) à la deuxième extrémité (38) du motif de câblage présent à la surface de ladite carte de circuit imprimé (33) ; et
un matériau moulé (40) qui couvre ledit dispositif à semiconducteur en laissant des parties desdits fils de sortie (34) non recouvertes ;
ledit matériau moulé (40) étant de la résine moulée ;
ladite carte de circuit imprimé (33) ayant une partie de surface envers au niveau du côté interne de la carte de circuit imprimé (33), ladite partie de surface envers étant une partie de la surface de ladite carte de circuit imprimé (33) qui est opposée à la surface sur laquelle ledit motif de câblage est disposé, et étant en chevauchement et lié avec ladite partie de surface périphérique de la base (31) entourant ladite puce semiconductrice (32) sans contact entre ladite carte de circuit imprimé (33) et ladite puce (32) ; et
ledit premier moyen de connexion étant des fils de liaison (31) et ledit deuxième moyen de connexion étant une bande TAB (39)

2. Dispositif à semiconducteur du type à encapsulation dans un matériau moulé selon la revendication 1, où :
une bosse est prévue sur la deuxième extrémité (38) du motif de câblage ; et
ladite bande TAB (39) utilise ladite bosse prévue sur ledit motif de câblage pour les connexions entre ladite deuxième extrémité du motif de câblage de la carte de circuit imprimé (33) et lesdits fils de sortie (34).

3. Dispositif à semiconducteur du type à encapsulation dans un matériau moulé selon la revendication 1, où ladite bande TAB (39) n'utilise aucune bosse prévue sur ladite carte de circuit imprimé (33) et lesdits fils de sortie (34) pour les connexions entre la deuxième extrémité du motif de câblage de la carte à circuit imprimé (33) et lesdits fils de sortie (34).

4. Dispositif à semiconducteur du type à matériau moulé permettant d'incorporer une pluralité de très petites puces semiconductrices (55 à 61) dans un boîtier, possédant une pluralité d'électrodes (67) disposées sur une surface de la puce semiconductrice (55 à 61), comprenant :
une pluralité de bases (51 à 54) ayant chacune une surface sur laquelle au moins l'une desdites puces semiconductrices (55 à 61) est montée, ladite surface ayant une partie de surface périphérique qui s'étend au-delà de la périphérie de ladite puce semiconductrice (55 à 61) ;
une pluralité de fils de sortie (66) entourant ladite pluralité de bases (51 à 54) ;
une pluralité de cartes de circuit imprimé (62 à 65) portant chacune un motif de câblage ayant des première et deuxième extrémités, se trouvant entre ladite puce semiconductrice (55 à 61) et lesdits fils de sortie (66) ;
des fils de liaison (69) connectant les électrodes (67) présentes sur chacune desdites puces semiconductrices (55 à 61) à la première extrémité (68) du motif de câblage se trouvant sur la surface de la carte de circuit imprimé correspondante (62 à 65) ;
une bande TAB (71) connectant lesdits fils de sortie (66) à des deuxièmes extrémités du motif de câblage se trouvant sur la surface desdites cartes de circuit imprimé (62 à 65) ; et
un matériau moulé (81) couvrant ledit dispositif à semiconducteur en laissant des parties desdits fils de sortie (66) non recouvertes ;
ledit matériau moulé (81) étant une résine moulée ;
chacune desdites cartes de circuit imprimé (62 à 65) ayant une partie de surface envers qui est fixée à ladite partie de surface périphérique de la base (51 à 54) entourant ladite puce semiconductrice (55 à 61) sans contact entre ladite carte de circuit imprimé (62 à 65) et ladite puce (55 à 61) ;
au moins une ouverture étant formée dans chacune des cartes de circuit imprimé (62 à 65) afin d'enfermer une puce semiconductrice respective (55 à 61) dans l'ouverture ou dans chaque ouverture ;
des bornes de connexion de cartes de circuit imprimé voisines qui sont connectées par des fils de liaison (70) ; et
des bornes de connexion se trouvant en regard des fils de sortie (66) et les fils de sortie étant connectés via lesdites bandes TAB (71).
